# EUROPÄISCHE PATENTSCHRIFT

(11) **EP 3 055 878 B1**
(45) Veröffentlichungstag und Bekanntmachung des Hinweises auf die Patenterteilung: **28.04.2021**
(21) Anmeldenummer: 14784002.9
(22) Anmeldetag: 08.10.2014
(51) Int. Cl.: H01L 21/677

(54) **REINRAUM-TRANSPORTBEHÄLTER MIT FAHRWERK**
CLEAN-ROOM TRANSPORT CONTAINER WITH TRAVEL GEAR
CONTENEUR DE TRANSPORT POUR SALLE BLANCHE POURVU D'UN TRAIN DE ROULEMENT

(30) Priorität: 08.10.2013 DE 102013016597; 08.10.2013 DE 102013016598
(43) Veröffentlichungstag der Anmeldung: 17.08.2016
(73) Patentinhaber: ASYS Automatic Systems GmbH & Co. KG, 73614 Schorndorf (DE)
(72) Erfinder: Hügler, Klaus, 73614 Schorndorf (DE)
(74) Vertreter: Müller, Gottfried
(86) Internationale Anmeldenummer: PCT/EP2014/002732
(87) Internationale Veröffentlichungsnummer: WO 2015/051915

(56) Entgegenhaltungen:
- WO-A2-02/15234
- WO-A2-99/12191
- DE-A1-102004 058 557
- US-A- 4 016 989
- US-A1- 2004 062 628
- US-B1- 6 364 331

## Beschreibung

Die Erfindung betrifft einen Reinraum-Transportbehälter gemäß dem Oberbegriff des Anspruches 1.

Unter Reinraumbedingungen zu behandelnde flächige Substrate weisen zunehmend größere Flächenmaße auf. Entsprechend der Anzahl der für eine solche Behandlung zu durchlaufenden Stationen sind dadurch - falls die Substrate während des ganzen Behandlungsdurchlaufs im Reinraum verbleiben sollen - sehr groß dimensionierte, in sich geschlossene Reinräume erforderlich, die technisch nur noch schwer zu realisieren und wirtschaftlich kaum noch zu vertreten sind. Alternativ hierzu werden deshalb die in einem Behandlungszyklus zu durchlaufenden Stationen für solch großflächige Substrate auf mehrere, jeweils unter Reinraumbedingungen zu betreibende Baueinheiten aufgeteilt. Dies mit der Folge, dass die jeweils zu behandelnden Substrate zwischen den Behandlungseinheiten umgesetzt werden müssen und dadurch mit verunreinigten Atmosphären in Berührung kommen oder durch mechanische Gegebenheiten bei der Umsetzung verunreinigt werden können.

Um dies zu vermeiden werden die Substrate zwischen unterschiedlichen Behandlungseinheiten in atmosphärisch geschlossenen Transportbehältern, häufig sogenannten SMIF- oder FOUP-Boxen umgesetzt, was bei großflächigen Substraten zu entsprechend voluminösen und schweren Transportbehältern führt. Dies bedingt mechanische Umsetzhilfen, da ein händisches Umsetzen zwischen den jeweiligen Behandlungseinheiten kaum noch machbar ist. Mechanische Umsetzeinrichtungen, wie beispielsweise Hängeförderer und automatisiert geführte Flurförderwagen, sind letztlich aber nur bei auf große Kapazitäten ausgelegten Anlagen wirtschaftlich vertretbar und kommen somit für auf kleinere Kapazitäten ausgelegte Anlagen kaum in Frage.

Dementsprechend ist es insbesondere für Anlagen kleinerer Kapazität und für die Behandlung von vor allem flächenmäßig meist kleineren Substraten zum Beispiel aus der DE 101 44 955 B4 bereits bekannt, für die die Substrate aufnehmenden Transportbehälter bei vor allem händischer Umsetzung zwischen Behandlungseinheiten - zur Erleichterung dieser Umsetzung mit der erforderlichen Präzision - der jeweiligen Behandlungseinheit, also beispielsweise einer Prozessstation, eine Übergabevorrichtung zuzuordnen, die ein Bauteil dieser Prozessstation bildet und die eine dem jeweiligen Beschicker geneigt zugewandte Tragabstützung für den jeweiligen, an die Prozessstation anzudockenden Transportbehälter aufweist. Zum Andocken des Transportbehälters an die jeweilige Ladeöffnung der Prozessstation wird der Transportbehälter durch Verschwenken der Tragabstützung in seine Andocklage gebracht, in der er mit seiner deckelseitigen Stirnfläche randseitig die Ladeöffnung dichtend umschließt, so dass nach Entfernen des Deckels ein Zugriff auf die im Transportbehälter mit Abstand geschichteten Substrate durch die Ladeöffnung möglich ist. Bis zum dichtenden Ansetzen des Transportbehälters ist die Ladeöffnung durch eine diese überdeckende, hubverschiebliche Torplatte geschlossen, die durch Verlagerung gegen den Deckel des Transportbehälters mit diesem verbunden wird, so dass durch die Hubverstellung der Torplatte diese und der Deckel in eine die Übergabeöffnung freigebende Öffnungsstellung versetzt werden. Schon die für großflächige Substrate, wie etwa 450 mm Wafer, erforderlichen Dimensionen für Transportboxen wie auch das Gewicht solcher, mit Wafern gefüllter Transportboxen machen deutlich, dass trotz solcher Hilfen händisch deren Handhabung schwer möglich ist.

Weiter ist es auch durch die DE 199 16 932 C1 bekannt, eine Übergabevorrichtung für plattenförmige Substrate als verfahrbare Montageeinheit auszubilden, die zur jeweiligen Behandlungseinheit oder einer jeweiligen Prozessstation lagefest stationär verbunden wird, derart, dass sie mit ihrer Beschicköffnung in Überdeckung zu einer entsprechenden Ladeöffnung in der Behandlungseinheit oder einer Prozessstation liegt. Zu diesen Öffnungen ist seitens der Übergabevorrichtung ein hubverstellbares Schleusentor vorgesehen.

Zur Erleichterung des Ansetzens eines Transportbehälters an einer solchen Übergabevorrichtung weist diese zwei in Hochrichtung teleskopisch gegeneinander verstellbare Kammerteile auf, zu deren oberem das Schleusentor in Hochrichtung überstehend lagefest angeordnet ist, derart, dass Beschick- und Ladeöffnung in der in dem unteren Kammerteil eingefahrenen Lage des oberen Kammerteils über das Schleusentor verschlossen sind. In dieser eingefahrenen Lage des oberen Kammerteils bildet dessen Oberseite eine in Zugriffshöhe liegende Tragabstützung, auf die ein jeweiliger Transportbehälter aufzusetzen ist. Durch Ausfahren des oberen Kammerteils aus dem unteren Kammerteil unter Verbleib des Gehäuses des Transportbehälters auf der die Oberseite des obigen Kammerteils als Tragabstützung bei Verriegelung des oberen Kammerteils in seiner ausgefahrenen Lage werden die im Transportbehälter gestapelten Substrate in den oberen Kammerteil überführt und so in eine Anschlusslage zu Beschick- und Ladeöffnung gebracht.

Weiter ist es aus der US 5 364 219 bekannt, gegebenenfalls automatisch geführte Flurförderwagen zur Beschickung von Behandlungseinheiten oder Prozessstationen zu verwenden, wobei seitens der Behandlungseinheit oder Prozessstation und des Flurförderwagens Übergabeöffnungen vorgesehen sind, die durch Andocken des Flurförderwagens dichtend umschlossen sind. Der Ladeöffnung der Behandlungseinheit oder Prozessstation ist ein über einen Hubantrieb verstellbares Schleusentor zugeordnet, das in der Andockstellung des Flurförderwagens zum dessen Beschicköffnung zugeordneten Deckel festgelegt und zusammen mit diesem in Hubrichtung verstellbar ist. Die seitens des Flurförderwagens vorgesehene Beschicköffnung ist einer Reinraumkammer zugeordnet, in der ein Handhabungsgerät vorgesehen ist, über das Zugriff auf die Behandlungseinheit sowie auf einen mit der Reinraumkammer gegenüberliegend in Verbindung stehenden, ebenfalls dem Flurförderwagen zugeordneten Ablageraum für Substrate genommen werden kann, so dass im Flurförderwagen verschiedenste Funktionen zusammengefasst sind, die eine recht spezielle Ausgestaltung bedingen.

Auch aus der US 5 609 459 ist ein System zum Be- und Entladen von Reinraumanlagen mit Substraten bekannt, die in einem geschlossenen Transportbehälter mit stirnseitiger Beschicköffnung aufgenommen sind, wobei der Transportbehälter, in einer Andocklage zu einer Station der Anlage positioniert, auf einer Tragabstützung der Station abgesetzt ist und die Beschicköffnung eine Anschlusslage zu einer Ladeöffnung dieser Station einnimmt.

Aus der WO 99/12191 A2 und in entsprechender Weise aus der WO 02/15234 A2 ist es für Reinraumanlagen bekannt, zu Übergabeöffnungen von stationären Arbeitsstationen jeweils ein Übergabeportal stationär anzuordnen. Dieses Übergabeportal ist als verfahrbare Montageeinheit überdeckend zur Übergabeöffnung der jeweiligen Arbeitsstation auswechselbar anzubringen. Das Übergabeportal weist ein Aufsetzpodest für Transportbehälter auf, die eine zur Übergabeöffnung der Arbeitsstation korrespondiere Übergabeöffnung aufweisen. Den seitens des Transportbehälters und des Übergabeportals vorgesehenen Übergabeöffnungen sind korrespondierende Deckelteile zugeordnet, die bei auf dem Aufsetzpodest abgesetzte Transportbehälter zur Freigabe der Übergabeöffnungen gemeinsam mittels einer dem Übergabeportal zugeordneten Verstelleinrichtung in eine den Übergabeweg freigebende Öffnungsstellung zu verbringen sind.

Das eine verfahrbare Montageeinheit bildende Übergabeportal ist bei der Montage über eine seitens der Arbeitsstation vorgesehene Schwenkabstützung aus einer gekippten Verfahrlage in eine zur Andockebene der Arbeitsstation parallele, aufrechte, die Übergabeöffnung überdeckende Festlage zur Arbeitsstation verschwenkbar und nur in dieser Festlage in seiner Funktion als Übergabevorrichtung für in Transportbehältern zugeführte Substrate zu nutzen.

Bei einer weiteren, aus der US 6,364,331 B1 bekannten, im Oberbegriff des Anspruches 1 berücksichtigten Transportvorrichtung für Reinraum-Transportbehälter wird ein atmosphärengeschlossener Transportbehälter über ein berädertes Fahrwerk als Arbeitseinheit gegen eine Andockebene einer Arbeitsstation verfahren und in einer Ausgangslage für den Andockprozess zu dieser Arbeitsstation über eine Kupplungsanordnung erfasst, die mit aufrechter Schwenkachse zwischen Fahrgestell und Arbeitsstation eine wechselseitige Ausrichtung ermöglicht. Der Transportbehälter ist zum Fahrwerk über einen Schwenkrahmen abgestützt der fahrwerksseitig um eine zur Fahrebene parallele Achse verschwenkbar ist, und zwar zwischen einer zur Andockebene geneigt stehenden Fahrlage und einer nach Heranfahren des Fahrwerks an die Andockebene erreichten, über eine Kupplungsanordnung erfassten und in die Andockebene eingeschwenkten Andocklage. Mit Erreichen der Andocklage werden am Schwenkrahmen gegen die Andockebene ausragende Kragarme auf einer Abstellfläche für den Transportbehälter gedämpft aufgesetzt und nach Übergabe des Transportbehälters wird das Fahrwerk mit dem Schwenkrahmen wieder von der Andockebene entfernt.

Grundsätzlich bieten die bekannten Lösungen zwar Möglichkeiten zur Erleichterung des Andockens von geschlossenen Transportbehältern an jeweilige Bearbeitungseinheiten oder Prozessstationen und zur Reduzierung oder Vermeidung von Verunreinigungen von jeweils vom Transportbehälter auf die jeweilige Anlage oder Station zu übergebenden Substraten. Diese Möglichkeiten beinhalten auch Lösungen, insbesondere in Verbindung mit Hubverstellung von Schleusentoren und/oder Deckeln, reibungsbedingt auftretende Verunreinigungen der jeweiligen Atmosphäre dadurch zu vermeiden, dass Schleusentore und/oder Deckel für die Hubverstellung durch Querverlagerung aus ihrer Anlage zur jeweiligen Dichtfläche abgehoben werden.

Diese Lösungen sind aber recht aufwändig und für große und schwere, eigenständige Transportbehälter kaum geeignet.

Die Erfindung zielt darauf ab, eine einfache und billige Lösung zum Umsetzen großer und schwerer, großflächige Substrate aufnehmender Transportbehälter zur Verfügung zu stellen, wobei eine solche Lösung technisch und wirtschaftlich insbesondere in Verbindung mit Anlagen kleinerer Kapazität von Vorteil sein soll und außerdem keinen Eingriff in den Aufbau einer solchen Anlage bedingen soll, der ein späteres Aufrüsten oder Umrüsten einer solchen Anlage auf größere Kapazitäten behindern würde. Erfindungsgemäß wird hierzu ein Reinraum-Transportbehälter mit Fahrwerk gemäß dem Anspruch vorgesehen. Mit den weiteren Ansprüchen werden zweckmäßige Ausgestaltungen angesprochen, die ebenso wie die Lösung gemäß dem Anspruch 1 nachstehend insbesondere orientiert auch an den Zeichnungen und ergänzt durch diese erläutert werden.

Gemäß dem Anspruch 1 bilden ein jeweiliger Reinraum-Transportbehälter für großflächige Substrate, somit also ein großer und schwerer Transportbehälter und ein Fahrwerk ein im Wesentlichen fest miteinander verbundene Arbeitseinheit in Form einer Bau- und Funktionseinheit, bei der ein jeweiliger Transportbehälter jeweils über ein Fahrwerk verfügt und getragen über dieses Fahrwerk längs einer Fahrebene insbesondere händisch, also vor allem über eine Bedienperson, zu verfahren und mit dem Fahrwerk sowie über das Fahrwerk auch anzudocken ist. Hierbei ist die Arbeitseinheit ungeachtet der jeweiligen Verfahrgeschwindigkeit und der gegebenenfalls auch großen Massen feinfühlig zu bewegen, um Erschütterungen und Bewegungsabläufe zu vermeiden, die zu atmosphärischen Verunreinigungen durch entsprechende Partikelbildung führen können.

Da insoweit insbesondere die Verhältnisse beim Andocken des Transportbehälters an die jeweilige Arbeitsstation kritisch sind, erfolgt dieses Andocken gesteuert und gedämpft mithilfe einer Einrichtung, die als Kupplungsanordnung ausgebildet ist und bei der für die Arbeitseinheit aus Fahrwerk und Transportbehälter die in der Verbindung zwischen Fahrwerk und Arbeitsstation liegende Schwenkachse eine liegende Tragachse für die Arbeitseinheit bildet. Fahrwerk und Transportbehälter bilden hierbei eine gegeneinander lagefest verbundene, unter Beibehalt ihrer Lage zueinander verschwenkbare Arbeitseinheit, die insgesamt zur Tragachse und um die Tragachse schwenkbar ist, wobei die Kupplungsanordnung im Hinblick auf diese Verschwenkbarkeit angetrieben ist und die Arbeitseinheit um die Tragachse in eine zur Fahrebene angehobene, insbesondere gegenüber der Fahrebene ausgehobene Anschlusslage zur jeweiligen Arbeitsstation verschwenkt wird.

Bei einer nicht erfindungsgemäßen Ausgestaltung der Kupplungsanordnung wird seitens der Tragachse ein auf das Fahrwerk auskragender Lastarm um die Tragachse verschwenkbar und angetrieben vorgesehen, der, eingreifend in das Fahrwerk und bevorzugt auch dämpfend gegen dieses abgestützt und/oder von diesem dämpfend aufgenommen ist, zu diesem ausgerichtet festgelegt, das Fahrwerk und damit die Arbeitseinheit um die Tragachse verschwenkend anheben kann. Über einen Schneckentrieb lässt sich der Lastarm bei gedrängter Bauweise mit einfachen Mitteln antreiben, wobei ein Schneckentrieb zusätzliche einfache Möglichkeiten der Fixierung jeweiliger Einstelllagen durch Selbsthemmung ermöglicht.

In einer erfindungsgemäßen Ausgestaltung gemäß Anspruch 1 umfasst die Kupplungsanordnung eine erste und eine zweite Kupplungseinheit. Der ersten Kupplungseinheit kommt dabei die Aufgabe zu, beim Ansetzen der Arbeitseinheit von Transportbehälter und Fahrwerk Letzteres bevorzugt etwa in Höhe der Fahrebene benachbart zur Andockebene abzufangen und abzustützen, um so eine gute Ausgangsposition für das Andocken des Transportbehälters gegen die Arbeitsstation zu schaffen.

Über die zweite Kupplungseinheit wird die Arbeitseinheit bevorzugt schon bei ihrer Annäherung an die Ausgangsposition erfasst, insbesondere auch dämpfend abgefangen und über die Ausgangsposition hinaus gegen die Andockebene verlagert, insbesondere um die über die erste Kupplungseinheit geschaffene Abstützung als Drehachse verschwenkt und in der dadurch geschaffenen Andocklage auch fixiert. Die zweite Kupplungseinheit kann hierzu in einfacher Weise im Wesentlichen durch einen Stellzylinder gebildet sein, der seitens der Arbeitsstation abgestützt ist und der bevorzugt sensorisch gesteuert mit einem seiner Stellstange zugeordneten Greifer auf ein entsprechendes, seitens des Fahrwerks vorgesehenes Gegenglied zugreift.

Diese Funktionen lassen sich, wie erkennbar, mit einfachen Mitteln erfüllen und bedingen insbesondere auch keine aufwändige Ausbildung des mit dem Transportbehälter zu einer Arbeitseinheit zusammengefassten Fahrwerks.

Die geschilderten Einrichtungen zum gedämpften Andocken des mit dem Fahrwerk zu einer Arbeitseinheit verbundenen Transportbehälters an eine jeweilige Arbeitsstation kommen insbesondere dann mit Vorteil zum Tragen, wenn Transportbehälter und Fahrwerk als Arbeitseinheit in ihrer Andocklage zu einer Arbeitsstation und in ihrer Fahrlage zur Fahrebene unterschiedlich geneigt sind, derart, dass die Arbeitseinheit eine zur Andocklage winklig gegen die Fahrebene abgesetzte Fahrlage aufweist, wie sie für den möglichst schonenden und auch innerhalb des Transportbehälters bewegungsarmen Transport der Substrate zweckmäßig ist, ebenso wie für die Handhabung der Arbeitseinheit durch eine jeweilige Bedienperson.

Ausgehend von einer Ausgangsposition zum Andocken, wie sie sich beim Verfahren der Arbeitseinheit in einer zur Andocklage winklig abgesetzten Fahrlage ergibt, ist über die erfindungsgemäße Ausgestaltung der Einrichtung zum gedämpften Andocken der Arbeitsstation der jeweilige Arbeitsablauf gut zu beherrschen.

Ein solches Verschwenken der Arbeitseinheit von der Ausgangsposition in die angedockte Lage mit lagefester Abstützung der Arbeitseinheit über die Kupplungsanordnung, oder über die erste Kupplungseinheit der Kupplungsanordnung im zur Fahrebene benachbarten Bereich führt dazu, dass die Arbeitseinheit aus ihrer zur Fahrebene über die gefederten Laufräder abgestützten Lage ausgehoben wird, somit allein über die Kupplungsanordnung in der Andocklage fixiert ist und aufgrund der Zwangsführung auch schon während des Andockens anderweitige Beeinflussungen der Arbeitseinheit, sei es über die Bedienperson oder bedingt durch Fahrbahngegebenheiten ausgeschlossen sind, welche die erforderliche exakte und erschütte-rungsfreie Umsetzung der Arbeitseinheit beeinträchtigen können.

Es ist erkennbar, dass sich ungeachtet der vorbesprochenen Ausgestaltung der Kupplungsanordnung eine besondere Flexibilität in der Anordnung von jeweiliger Arbeitseinheit und zu beschickenden Arbeitsstationen ergibt, wenn die Kupplungsanordnung einem Zwischenbauteil zugeordnet wird, so dass zum Beispiel für die Anpassung an Anlagen mit Änderungen an den Arbeitsstationen und/oder den Arbeitseinheiten unterschiedliche Zwischenbauteile Verwendung finden können.

Die Erfindung wird nachfolgend anhand der Zeichnungen näher erläutert, wobei in den
Fig. 1 bis 6
   eine im Wesentlichen am Funktionsprinzip orientierte Darstellung eines Reinraumbehälters mit Fahrwerk in Verbindung mit einem Ausschnitt einer Reinraumanlage gezeigt ist, die durch eine Station einer solchen Reinraumanlage veranschaulicht ist, an der der Transportbehälter über sein Fahrwerk und mit seinem Fahrwerk anzudocken ist und wobei diese Figuren den Ablauf eines diesbezüglichen Andockvorganges veranschaulichen,

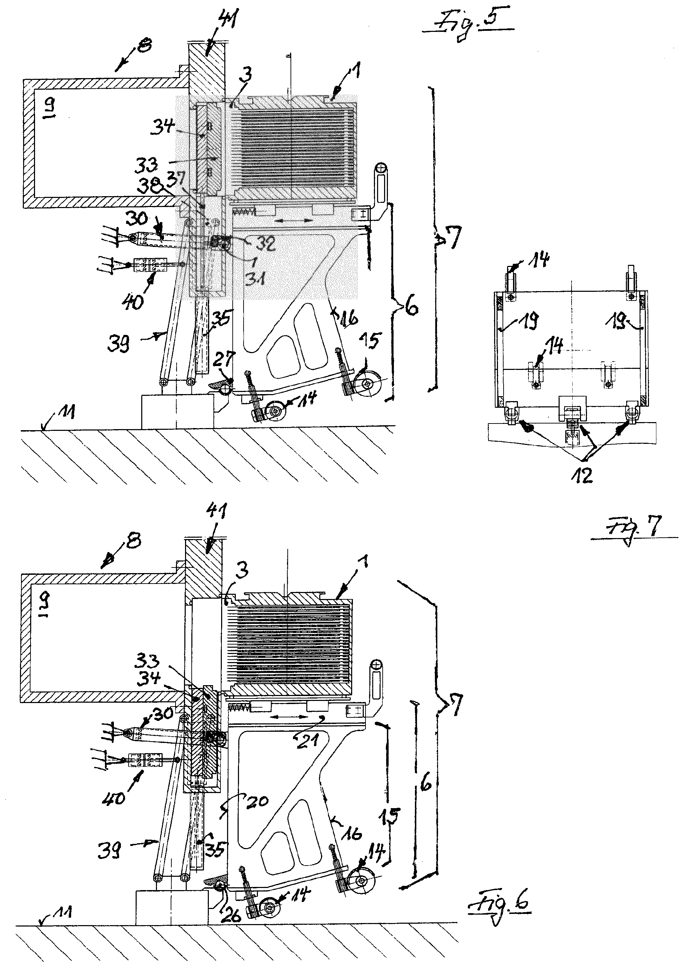

Fig. 7 eine schematisierte Ansicht eines Fahrwerks entsprechend einer Schnittführung VII in Fig. 6 zeigt, und wobei
Fig. 8 bis 14
   bei gleichem Funktionsprinzip wiederum einen Ablauf des Andockens zwischen vom Fahrwerk getragenem Transportbehälter und einer Station einer Reinraumanlage zeigen, und zwar bezogen auf eine weitere konstruktive Ausgestaltung insbesondere des Zwischenbauteiles, das bei an die Prozesskammer einer jeweiligen Arbeitsstation angedocktem Fahrwerk mit Transportbehälter lagefest zur Arbeitsstation angeordnet eine zwischen Prozesskammer und Transportbehälter liegende Übergangsöffnung enthält und das sowohl Hilfsmittel zum automatisierten Andocken des insbesondere händisch an das Zwischenbauteil herangeführten Fahrwerks mit Transportbehälter aufnimmt wie auch die Verstellmittel für Deckel, über die der Zugang zur Arbeitskammer und zum Transportbehälter im Bereich der Übergangsöffnung zu versperren ist, wobei das Zwischenbauteil bevorzugt auch einen abgesonderten Reinraumteil bilden kann, insbesondere mit Spülanschlüssen für diesen Reinraumteil.

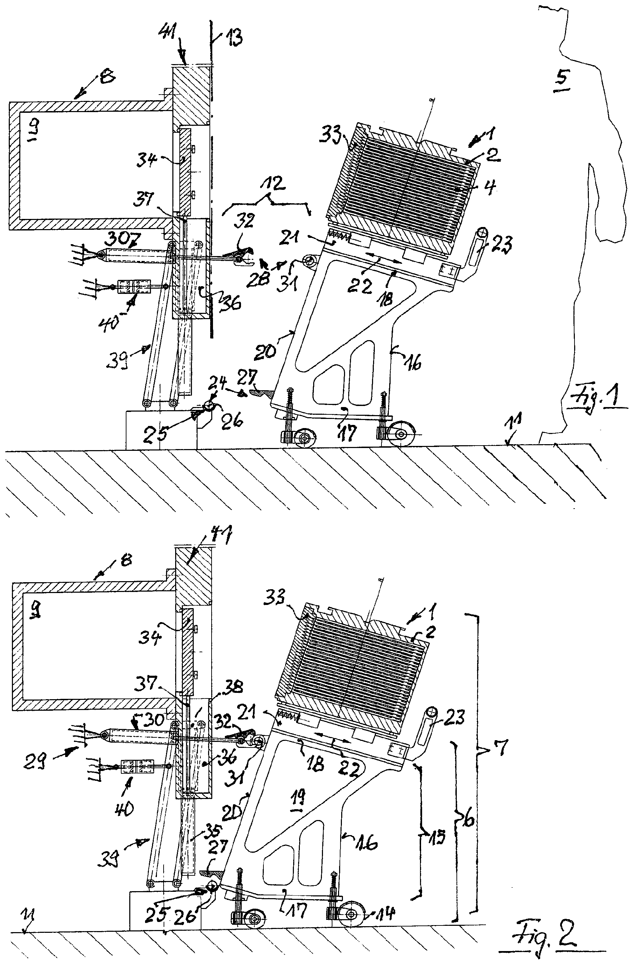

Zunächst wird auf die Fig. 1 bis 7 Bezug genommen, die zeigen, dass der Transportbehälter 1 als ein atmosphärisch geschlossener Transportbehälter mit in seinem Gehäuse 2 vorgesehener frontseitiger Beschicköffnung 3 - als sogenannte FOUP oder SMIF - ausgebildet ist, in dem mit Abstand gestapelt übereinanderliegend Substrate 4 aufgenommen werden. Die Substrate 4 sind als großflächige Substrate beispielsweise durch Wafer mit einem Durchmesser von 450 mm gebildet. Dementsprechend ergibt sich aufgrund der Aufnahme eines Stapels von Substraten 4, also beispielsweise Wafern in dem Transportbehälter 1 für diesen ein großes Volumen mit einem entsprechenden Gewicht, das über eine Bedienperson 5, in Fig. 1 angedeutet, auch bei günstigen Arbeitsgegebenheiten kaum noch zu beherrschen ist.

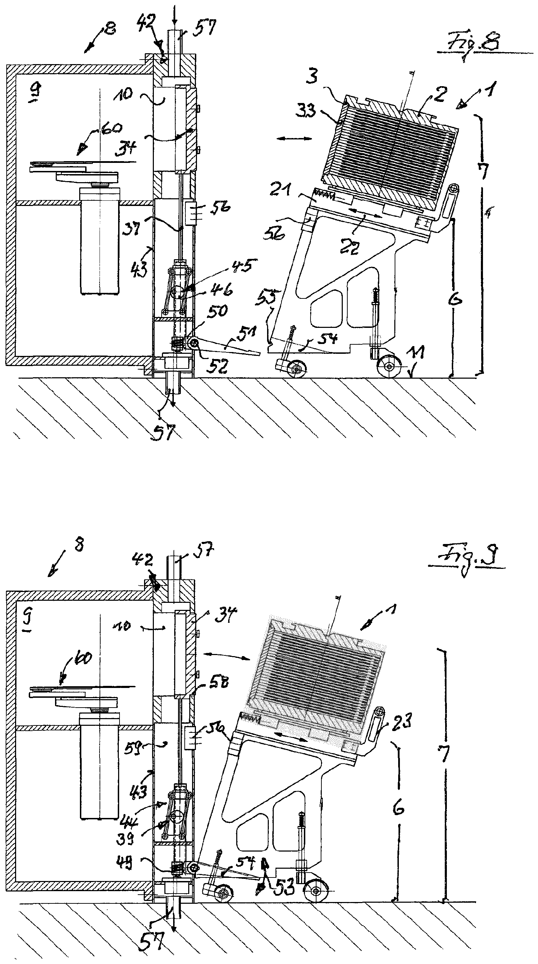

Im Hinblick darauf ist dem Transportbehälter 1 ein Fahrwerk 6 zugeordnet und es bilden Fahrwerk 6 und Transportbehälter 1 eine Funktions- und Baueinheit, die als Arbeitseinheit 7 innerhalb der jeweiligen Reinraumanlage zur Umsetzung von Substraten 4 zwischen den Arbeitsstationen 8 der Reinraumanlage eingesetzt ist, wobei die Arbeitseinheit 7 bevorzugt mit einer eigenen Energieversorgung - beispielsweise über eine Steckkupplung 56, siehe Fig. 8 bis 15 - ausgestattet oder an eine externe Energieversorgung anzuschließen ist. Insbesondere im Hinblick auf einen möglichst variablen Einsatz einer solchen Arbeitseinheit 7 kann das Fahrwerk 6 mit dem Transportbehälter 1 auch lösbar verbunden sein, so dass durch Bestückung mit unterschiedlichen Transportbehältern 1 auch eine Anpassung an variable Betriebsgegebenheiten in einer Anlage möglich ist.

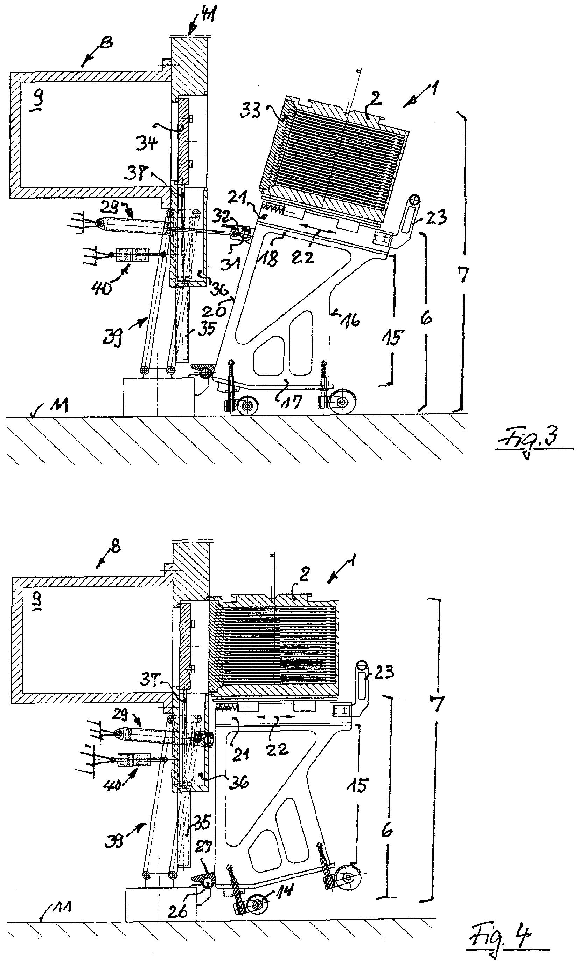

Eine jeweilige Arbeitseinheit 7 ist für die Übergabe von Substraten 4 zwischen Transportbehälter 1 und einer jeweiligen Arbeitsstation 8 bereit, wenn die Arbeitseinheit 7 in ihrer Andocklage zur Arbeitsstation 8 fixiert ist, wie in den Fig. 4 bis 6 gezeigt, und wenn der Transportbehälter 1 über seine Beschicköffnung 3, gegen die Umgebungsatmosphäre dichtend abgegrenzt, in offener Verbindung zur Be- und Entladeöffnung 10 der Prozesskammern 9 der Arbeitsstation 8 steht, wie in Fig. 6 gezeigt.

Auf die jeweilige Andocklage zu einer Arbeitsstation 8 ist die Arbeitseinheit 7 zunächst längs einer Fahrebene 11, im Regelfall über eine Bedienperson 5, auf eine Annäherungslage zu der Arbeitsstation 8 verfahrbar, an der die Arbeitseinheit 7 angedockt werden soll. Die Annäherungslage der Arbeitseinheit 7 wird bevorzugt sensorisch erfasst, was hier nicht gezeigt ist, und ist in Fig. 2 veranschaulicht. In dieser Annäherungslage liegt die Arbeitseinheit 7 im Zugriffsbereich der Kupplungsanordnung 12, die Kupplungseinheiten 24 und 28 mit der Arbeitsstation 8 und der Arbeitseinheit 7 zugehörigen Kupplungsteilen aufweist.

In ihrer Verfahrlage zur Fahrebene 11 nimmt die Arbeitseinheit 7 eine insgesamt zur Andockebene 13 zwischen Arbeitseinheit 7 und Arbeitsstation 8 winklige und entgegengesetzt zur Anfahrrichtung gegen die Andockebene 1 geneigte Lage gegenüber der Fahrebene 11 ein, wie in den Fig. 1 und 2 veranschaulicht. Dies bei auf der Fahrebene 11 aufsitzenden Laufrädern 14 des Fahrwerkes 6, das einen über die Laufräder 14 getragenen Aufbau 15 aufweist, der sich bevorzugt als einfacher gerüstartiger Aufbau entsprechend der in der Verfahrlage des Fahrwerks 6 geneigten Lage zur Fahrebene 11 geneigt erstreckt.

In seiner, wie aus den Fig. 1 bis 7 ersichtlich, einfachen Gestaltung weist der Aufbau 15 in der Seitenansicht gemäß Fig. 1 bis 6 eine U-förmige, entgegen der Andockrichtung und damit zur Rückseite 16 offene Grundform mit einer die Laufräder 14 abstützenden Tragplatte als unterem Schenkel 17 und einer Tragauflage als oberem Schenkel 18 auf. Die tragende Abstützung zwischen unterem Schenkel 17 und oberem Schenkel 18 wird durch seitliche Wangen 19 gebildet, die eine Frontseite 20 aufweisen. Die Frontseite 20 erstreckt sich, entsprechend der geneigten Lage des Fahrwerks 6 zur Fahrebene 11, in der Fahrlage geneigt zur Fahrebene 11 und liegt bezogen auf den Transportbehälter 1 der Arbeitseinheit 7 im Wesentlichen in einer Ebene mit dessen Frontseite.

Im Übergang zwischen dem oberen Schenkel 18 des Aufbaus 15 und dem aufsitzenden Transportbehälter 1 ist, bevorzugt als separates Bauteil mit dem Aufbau 15 auswechselbar verbunden, als Tragauflage 21 für den Transportbehälter 1 ein Funktionselement vorgesehen, über das der Transportbehälter 1 relativ zum Aufbau 15 des Fahrwerkes 6 entsprechend dem Pfeil 22 in oder entgegengesetzt zur Fahrrichtung der Arbeitseinheit 7 verstellbar ist. Zweckmäßigerweise ist im Bereich oder an der Tragauflage 21 auch eine Handhabe 23 für die Arbeitseinheit 7 vorgesehen. Zweckmäßigerweise sind der Tragauflage 21 Funktionselemente zur Identifizierung des Transportbehälters 1, zur fixierten Positionierung des Transportbehälters 1 gegenüber dem Fahrwerk 6 und/oder zur Positionierung des Fahrwerkes 6 zugeordnet, wobei in Verbindung mit einer entsprechenden elektrischen Versorgung u. a. die Positionierung und/oder Fixierung im Rahmen einer Automatisierung des Andockvorganges insbesondere gesteuert abläuft und entsprechende motorische Stellelemente, insbesondere Stellmotoren zur Tragauflage 21 vorgesehen sind.

Die sich entsprechend vorstehender Erläuterungen ergebene Neigung der Arbeitseinheit 7 gegenüber der Fahrebene 11 entgegengesetzt zur Andockrichtung hat in vorteilhafter Weise zur Folge, dass die im Transportbehälter 1 aufgenommenen Substrate 4 in der Fahrstellung der Arbeitseinheit 7 entgegen der Fahrtrichtung schräg nach hinten geneigt sind, somit für die Substrate 4 eine schwerkraftabgesicherte rückwärtige Lage gegeben ist, die einem erschütterungsbedingten Verrutschen der Substrate 4, unter anderem aufgrund von im Fahrbetrieb trotz aller Dämpfung sich ergebender Erschütterungen, entgegenwirkt. Die in der Fahrlage gegen die Fahrebene 11 abgeknickte Ausbildung des Aufbaus 15 des Fahrwerks 6 hat weiter zur Folge, dass der Transportbehälter 1 mit dem oberen Teil des Aufbaus 15 gegenüber der durch die Laufräder 14 gegebenen Abstützfläche zur Fahrebene 11 nach hinten auskragt, was günstige Arbeitspositionen für die jeweilige Bedienperson 5 sowohl beim Verfahren der Arbeitseinheit 7 mit sich bringt wie auch ein etwa notwendiges Aufsetzen eines gefüllten Transportbehälters 1 auf das Fahrwerk 6 erleichtert.

Bedingt durch die entgegen der Verfahrrichtung auf die Andocklage geneigte, zur Fahrebene 11 abknickende Ausbildung der Arbeitseinheit 7 ergibt sich ausgehend von der Annäherungslage ein Verschwenken der Arbeitseinheit 7 durch die Abstützung und das Zugreifen der Kupplungsanordnung 12 mit seiner ersten Kupplungseinheit 24, die im eingekuppelten Zustand eine nahe der Fahrebene 11 liegende Drehabstützung für die angekoppelte Arbeitseinheit 7 bildet. Die erste Kupplungseinheit 24 ist, wie insbesondere aus Fig. 2 und 7 ersichtlich, über frontseitig nahe den Wangen 19 des Aufbaus 15 liegende Drehabstützungen 25 gebildet, die eine zur Andockebene 13 parallele Drehachse festlegen und jeweils eine zur Arbeitsstation 8 lagefeste Stützkugel 26 und zu den Stützkugeln 26 bevorzugt verrastende, am Aufbau 15 vorgesehene Stützarme 27 aufweisen.

Eine zweite Kupplungseinheit 28 ist in Hochrichtung beabstandet zur ersten Kupplungseinheit 24 etwa mittig zu deren Drehabstützungen 25 liegend angeordnet und durch eine Stelleinrichtung 29 gebildet, die einen seitens der Arbeitsstation 8 abgestützten Stellzylinder 30 und einen seitens des Aufbaus 15 angeordneten Stützkörper 31, insbesondere in Form einer Stützkugel, aufweist, auf den der Stellzylinder 30 mit einer an seiner Kolbenstange endseitig vorgesehenen, bevorzugt gesteuert zwischen ihrer Fang- und ihrer Offenlage umstellbaren Fangklaue 32 zugreift.

Dieser Zugriff erfolgt, wie insbesondere aus Fig. 2 ersichtlich, bevorzugt sensorgesteuert - der Sensor ist nicht dargestellt - auf den Stützkörper 31 in der Andocklage, so dass, wie in Fig. 3 gezeigt, bei über die Kupplungseinheiten 24 und 28 erfasster Arbeitseinheit 7 diese gegen die Andockebene 13 abgestützt über die Drehabstützung 25 bei entsprechender Beaufschlagung des Stellzylinders 30 eingeschwenkt wird. In der so erreichten Andocklage des über die Kupplungseinheiten 24, 28 verschwenkten und den Transportbehälter 1 tragenden Fahrwerks 6 kann der Transportbehälter 1 lagepositioniert zur Tragauflage 21 über eine der Tragauflage 21 zugeordnete Stelleinrichtung - entsprechend dem Pfeil 22 - justierend verstellt werden, so dass in Verbindung mit dem Verschwenken der Arbeitseinheit 7 aus der Aufsetzlage der Räder 14 zur Fahrbahnebene 11 und dem Einschwenken gegen die Andockebene 13 zur Andockebene 13 gegebene Positionierungsungenauigkeiten des Transportbehälters 1 durch Verlagerung des Transportbehälters 1 gegenüber seinem die Andocklage bestimmenden Fahrwerk 6 reibungsfrei ausgeglichen werden können, die insgesamt fixierte Lage von Transportbehälter 1 und Fahrwerk 6 als Arbeitseinheit 7 aber erhalten bleibt.

Dem Transportbehälter 1 zur Beschicköffnung 3 und der Arbeitsstation 8 zur Be- und Entladeöffnung 10 ihrer Prozesskammer 9 sind Deckel 33, 34 zugeordnet, die in der Andocklage der Arbeitseinheit 7 zur Arbeitsstation 8 in Überdeckung zueinander liegen und die in dieser Andocklage, gegen die Umgebungsatmosphäre abgeschirmt, miteinander verbunden und über einen gemeinsamen Antrieb, insbesondere einen Hubantrieb 35, in eine die Öffnungen 3 und 10 freigebende Lage in der Seitenkammer 36 verlagerbar sind. Zur Verbindung der Deckel 33 und 34 im Hinblick auf deren Verstellung in ihre Öffnungsstellung wird der Deckel 34 gegen den Deckel 33 angelegt und verriegelt, wobei diese Querverstellung durch eine entsprechende Querverlagerung der Hubstange 37 des Hubantriebes 35 erfolgt. Hierzu ist die Hubstange 37 mit dem Joch 38 eines Lenkerparallelogramms 39 verbunden, das über einen Stellzylinder 40 mit gegeneinander aus ihrer Mittellage als Ruhelage verstellbaren Kolben verschwenkbar ist. Die Seitenkammer 36, die in einem Zwischenbauteil 41 vorgesehen ist, erstreckt sich zwischen der Andockebene 13 - durch eine Seite der Seitenkammer 36 bestimmt - und gegenüberliegender Arbeitsstation 8 - bevorzugt als eigenständiges Zwischenbauteil 41, so dass, wie bereits ausgeführt, durch Gestaltung dieses Zwischenbauteiles 41 eine Anpassung an zum Beispiel unterschiedliche Transportbehälter 1 ohne weitergehende Eingriffe in den Gesamtaufbau vorgenommen werden kann.

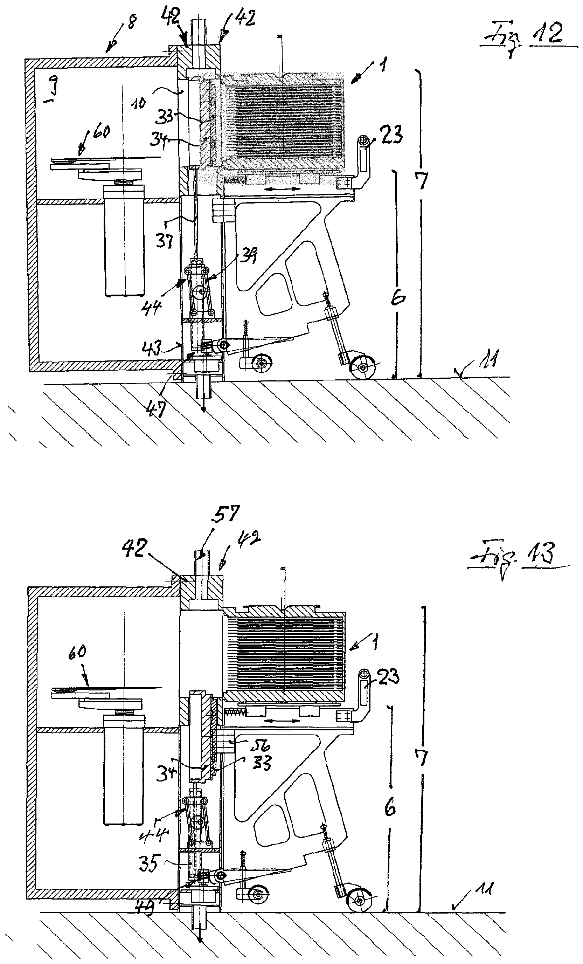

In Berücksichtigung der Ausführungen zu den Fig. 1 bis 7, anhand derer die funktionalen Zusammenhänge eingehend erläutert sind, zeigen die Fig. 8 bis 15 eine diesbezüglich weitgehend nur konstruktiv abgeänderte, aber in der Funktion erweiterte Bauform für ein Zwischenbauteil 42, das anstelle eines Zwischenbauteils 41 gemäß Fig. 1 bis 7 mit der Arbeitsstation 8 verbunden ist, die in den Fig. 8 bis 15 als ein Baukörper veranschaulicht ist, der zum Zwischenbauteil 42 in einer Anschlussfläche 43 ausläuft, die einen flächig überdeckenden Anschluss an das Zwischenbauteil 42 ermöglicht. Die Arbeitsstation 8 ist - bei rückgreifend auf die Fig. 1 und 7 weitgehend entsprechenden Bezugszeichen für einander zumindest in der Funktion entsprechende Bauteile - wiederum mit einer Prozesskammer 9 versehen, die eine Be- und Entladeöffnung 10 aufweist, welche zu einer entsprechenden Beschicköffnung 3 eines Transportbehälters 1 in dessen angedockter Lage korrespondiert. Die Be- und Entladeöffnung 10 im Zwischenbauteil 42 ist wiederum über einen Deckel 34 versperrbar, der zu einem der Beschicköffnung 3 zugeordneten Deckel 33 korrespondierend vorgesehen und mit diesem zu verbinden ist. Die Verbindung erfolgt mithilfe einer Stellvorrichtung 44, die sowohl zur Verstellung der Deckel 33, 34 zwischen ihren Sperrlagen zum Transportbehälter 1 und zur Prozesskammer 9 dient, wie auch zu deren Hubverstellung ausgehend von ihrer gegeneinander verblockten Lage zwischen Transportbehälter 1 und Prozesskammer 9 und einer den Durchgangsweg zwischen Transportbehälter 1 und Prozesskammer 9 freigebenden Öffnungslage, in der die Deckel 33, 34 im Zwischenbauteil 42 in Höhenrichtung verfahren eine den Durchgangsweg freigebende Lage einnehmen, wie in Fig. 13 gezeigt.

Damit ist bezogen auf die Hubverstellung der Deckel 33, 34 eine Ausbildung des Zwischenbauteiles 42 gegeben, die einen flächig überdeckenden Anschluss an die angrenzende Arbeitsstation 8 ohne wechselseitige Durchdringungen ermöglicht. Dies dadurch, dass nunmehr der mit dem Deckel 34 verbundene Hubantrieb 35 im Zwischenbauteil 42 aufgenommen ist, und zwar einschließlich des Lenkerparallelogramms 39, über das die mit dem Deckel 34 verbundene Hubstange 37 einschließlich zugehörigem Stellzylinder 35 in Querrichtung verlagert wird. Diese Verlagerung kann in einfacher Weise über einen Exzentertrieb 45 mit einer Exzenterscheibe 46 erfolgen, welche beispielsweise zwischen den Lenkern des Lenkerparallelogramms 39 platziert ist, derart, dass entsprechend der Drehstellung der Exzenterscheibe 46 das Lenkerparallelogramm 30 mit der Hubstange 37 die Deckel 33, 34 quer zwischen der Beschicköffnung 3 und der Be- und Entladeöffnung 10 verlagert.

In weiterer nicht erfindungsgemäßer Ausgestaltung kann, wie aus den Fig. 8 bis 15 ersichtlich, eine Stelleinrichtung 47 zum gemeinsamen Überführen von Fahrwerk 6 und Transportbehälter 1 als Arbeitseinheit 7 aus einer Verfahrlage in eine angehobene, zur Arbeitsstation 8 angedockte Lage in das Zwischenbauteil 1 eingefügt sein, ohne dass dadurch die Anschlussfläche 43 durchbrochen wird. Hierzu ist, wie aus den Fig. 8 bis 15 ersichtlich, im Zwischenbauteil 42 ein motorischer Antrieb 48, insbesondere ein Elektromotor, und diesem zugeordnet, ein Antriebsglied 49, insbesondere in Form einer Antriebsschnecke, vorgesehen, welche mit einem Zahnsegment 50 kämmt, über welches ein Schwenkhebel 51 um eine liegende Achse 52 verschwenkbar ist. Bei gegen das Zwischenbauteil 42 herangeschobenem Fahrwerk 6 nimmt dieses eine auf dem Schwenkhebel 51 zur Achse 52 zentrierte Lage ein, so dass durch Verschwenkung des Schwenkhebels 51 in Hochrichtung gemäß Pfeil 53 das Fahrwerk 6 mit dem Transportbehälter 1 in eine Andocklage zur Prozesskammer 9 eingeschwenkt wird. Die Verbindung des Schwenkhebels 51 zum Fahrwerk 6 lässt sich in einfacher Weise lagesicher dadurch gestalten, dass das Fahrwerk 6 mit einer entsprechenden Aufnahmetasche 54 versehen wird und über die Aufnahmetasche 54, beispielsweise deren Seitenwände, eine zentrierende Abstützung zur Achse 52 erfolgt, eine Möglichkeit, wie sie in Fig. 8 über Kerben 55 in Seitenwänden zur Aufnahmetasche 54 veranschaulicht ist. Insbesondere ist der Schwenkhebel 51 auch gedämpft zur Aufnahmetasche 54 von dieser aufgenommen, so dass die Einführung des Schwenkhebels 51 in die Aufnahmetasche 54 weitgehend erschütterungsfrei möglich ist. Eine derartig gestaltete Stelleinrichtung 47 lässt sich mit geringem Aufwand realisieren und ermöglicht auch mit einfachen Mitteln eine sichere Positionierung von Fahrwerk 6 und Transportbehälter 1 in der eingeschwenkten Andocklage, beispielsweise schon aufgrund einer Ausbildung des Antriebselementes 47 als Schnecke mit entsprechender Selbsthemmung. Mit einer solchen Stelleinrichtung 47 lässt sich auch arbeiten, wenn die Arbeitseinheit 7 in ihrer Fahrstellung nahezu senkrecht mit Fahrebene 11 ausgerichtet ist und für den Andockvorgang nur ein sehr kleiner Schwenkwinkel erforderlich ist, um die jeweils geforderte dichte Andocklage zu erreichen.

Eingeschwenkt in die Andocklage ist bei der dargestellten Lösung zweckmäßigerweise auch die Energieversorgung der Arbeitseinheit 7 von Fahrwerk 6 und Transportbehälter 1 über eine Steckkupplung 56 sichergestellt, so dass das beräderte Fahrwerk 6 in einfachster Weise und möglichst leicht aufgebaut werden kann und über die zum Fahrwerk 6 vorgesehene Tragauflage 21 auch der Transportbehälter 1, wie durch den Pfeil 22 beispielsweise in Fig. 3 angedeutet, bei angedocktem Fahrwerk 6 in eine abgedichtete Andocklage zum Zwischenbauteil 42 verfahren werden kann.

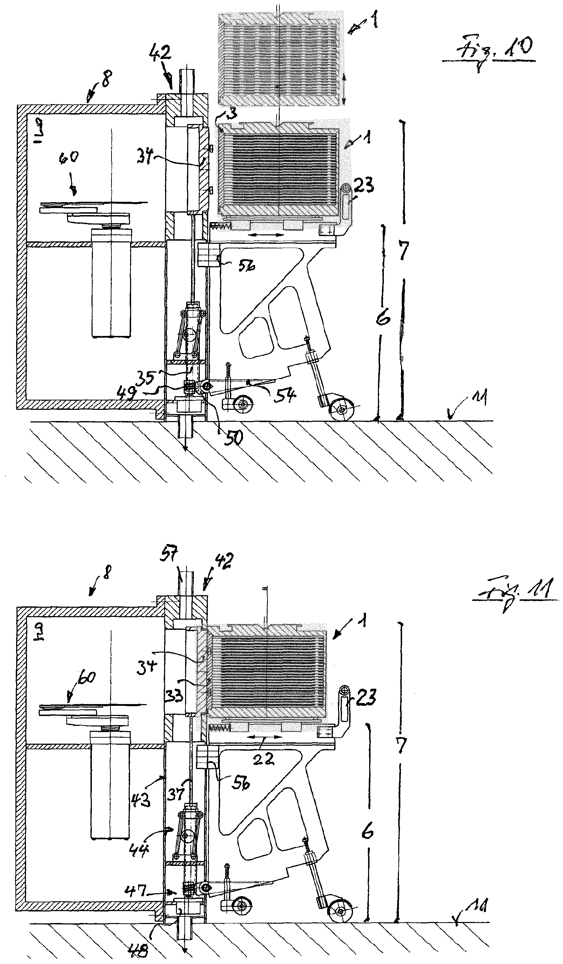

Damit sind auch die Voraussetzungen geschaffen, unter Verbleib des zur Arbeitsstation angedockten Fahrwerkes 6 praktisch als Tragpodest, Transportbehälter 1, wie in Fig. 10 angedeutet, auszutauschen, so dass beispielsweise Hängefördersysteme und Systeme mit längs einer Fahrebene 11 verfahrbaren Arbeitseinheiten aus Fahrwerk 6 und Transportbehälter 1 einander ergänzend betrieben werden können.

Bei der nicht erfindungsgemäßen Lösung gemäß Fig. 8 bis 15 ist das Zwischenbauteil 42 bevorzugt so als Teil der Verbindung zwischen Arbeitsstation 8 und Transportbehälter 1 ausgestaltet, dass es auch einen eigenständigen Reinraumbereich bilden kann, wenn das Zwischenbauteil 42 über den Deckel 34 einerseits und über das Gehäuse 2 des angedockten Transportbehälters 1 andererseits gegen die umgebende Atmosphäre abgedichtet ist. Das Zwischenbauteil 42 kann in Abhängigkeit von der Stelllage der Deckel 33, 34, auch unabhängig voneinander, an eine Spülluftversorgung angeschlossen werden können, die über Anschlüsse 57 zum Zwischenbauteil 42 symbolisiert ist, womit auch die Möglichkeit eröffnet ist, die Prozesskammer 9 mit dem Innenraum 59 des Zwischenbauteils 42 atmosphärisch zu verbinden.

Vereinfacht ist eine solche Anschlussverbindung bei der Ausgestaltung gemäß Fig. 8 bis 15 dadurch, dass der Deckel 34, der in der Anschlussverbindung vom Zwischenbauteil 42 zur Prozesskammer 9 liegt, unter Freigabe dieses Verbindungsweges in eine zweite Sperrlage verlagerbar ist, in der über diesen Deckel 34 eine zur Beschicköffnung 3 des angedockten Transportbehälters 1 korrespondierende Übergabeöffnung 58 in der dem Transportbehälter 1 zugewandten Seite des Zwischenbauteils 42 verschlossen wird. Diese Schließlage ist beispielsweise in den Fig. 8 und 9 ersichtlich, wobei ausgehend von dieser Schließlage und bei gegen den Deckel 34 herangefahrenem Deckel 33 des Transportbehälters 1, entsprechend der in Fig. 11 dargestellten Situation, beide Deckel 33, 34 nun in eine Zwischenlage zwischen ihren Schließstellungen gemäß Fig. 12 über die Stellvorrichtung 44 verschwenkt und aus dieser Zwischenstellung in ihre Ablagestellung gemäß Fig. 13 verbracht werden können.

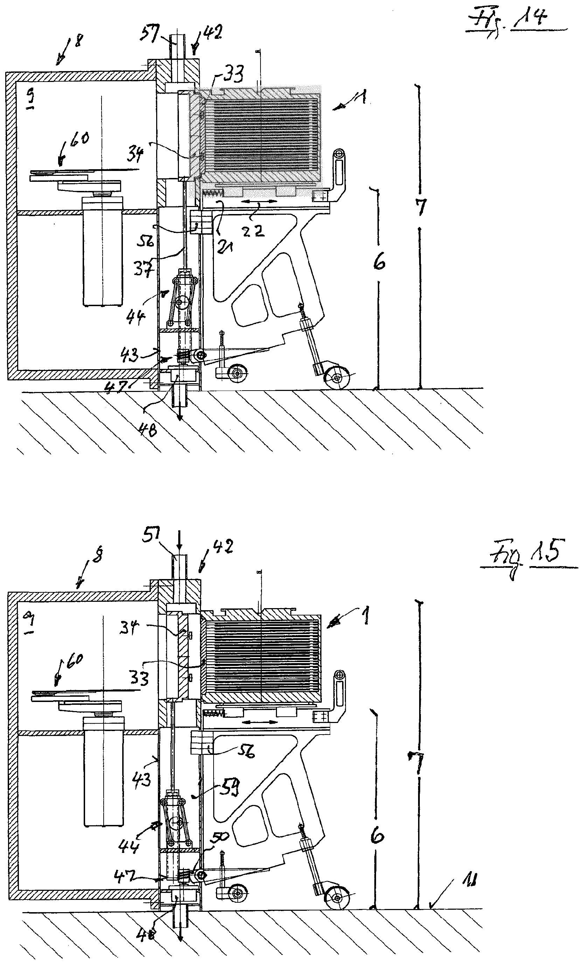

Der Deckel 34 ist somit, insgesamt gesehen, über die Stellvorrichtung 44 zwischen Sperrstellungen verfahrbar, in deren einer, siehe Fig. 15, der von der Spülluft durchflutbare Innenraum 59 des Zwischenbauteils 42 gegen die Prozesskammer 9 und die in dieser angeordneten Handhabungsvorrichtung 60 abgesperrt ist, und in deren gegenüberliegender Sperrstellung der Innenraum 59 des Zwischenbauteils 42 durch Verschließen der Übergabeöffnung 58 durch den Deckel 34 der Innenraum 59 des Zwischenbauteils 42 gegen die jeweilige Umgebungsatmosphäre abgeschlossen ist, wenn der Transferbehälter 1 nicht gegen das Zwischenbauteil 42 angedockt ist.

Insgesamt gesehen ist somit bei der erfindungsgemäßen Lösung der Deckel 34 als Sperrelement einerseits gegen die Prozesskammer 9 und andererseits gegen Umgebungsatmosphäre eingesetzt und bildet zudem bei angedocktem Transportbehälter 1 ein Kupplungs- und Tragelement für den der Beschicköffnung 3 des Transportbehälters 1 zugeordneten Deckel 33.

Die erfindungsgemäße Lösung ermöglicht für großvolumige und schwere Transportbehälter 1 in Reinraumanlagen deren Verlagerung zwischen Andocklagen zu verschiedenen Arbeitsstationen 8 durch die Zusammenfassung eines jeweiligen Transportbehälters 1 mit einem jeweiligen Fahrwerk 6 zu einer Arbeitseinheit 7, die zwischen ihren jeweiligen Andocklagen zu den Arbeitsstationen 8 verfahrbar ist und bei der der Transportbehälter 1 in der jeweiligen Andocklage durch sein zur Arbeitsstation 8 angedocktes Fahrwerk 6 getragen ist.

Nicht dargestellt ist in den Zeichnungen, dass die Arbeitseinheit 7 mit einem Anschluss an eine Energieversorgung versehen ist, bevorzugt durch einen im Bereich einer der Kupplungsanordnungen 24 oder 28 vorgesehenen Kupplungsanschluss.

## Patentansprüche

1. Reinraum-Transportbehälter mit Fahrwerk,
∘ wobei der atmosphärengeschlossene Transportbehälter (1) für Substrate (4) eine verschließbare stirnseitige Beschicköffnung (3) aufweist und über das beräderte, auf einer Fahrebene (11) aufsitzende Fahrwerk (6) als Arbeitseinheit (7) getragen in eine Ausgangslage zum Andocken gegen eine Andockebene (13) einer Arbeitsstation (8) in einer zur Andockebene (13) geneigten Fahrlage zu verfahren ist,
∘ wobei eine Kupplungsanordnung (12) mit einer Kupplungseinheit (24) vorgesehen ist, über die in der Ausgangslage zum Andocken das Fahrwerk (6) und der von diesem getragene Transportbehälter (1) als Arbeitseinheit (7) fahrwerksseitig nahe der Fahrebene (11) und zur Andockebene (13) der Arbeitsstation (8) benachbart abgestützt sowie erfasst und über eine Schwenkachse gehalten ist, und
∘ wobei der Transportbehälter (1) in eine Andocklage zur Arbeitsstation (8) verschwenkbar ist,
**dadurch gekennzeichnet**,
∘ dass die Schwenkachse für die das Fahrwerk (6) und den Transportbehälter (1) umfassende Arbeitseinheit (7) durch Drehabstützungen (25) gebildet ist, die jeweils eine zur Andockebene (13) der Arbeitsstation (8) parallele Drehachse als Tragachse festlegen und jeweils durch eine zur Arbeitsstation lagefeste Stützkugel (26) gebildet sind,
∘ dass das Fahrwerk (6) und der über das Fahrwerk (6) getragene Transportbehälter (1) bezogen auf die Tragachse zueinander lagegesichert und insgesamt - als lagefest verbundene, verschwenkbare Arbeitseinheit (7) unter Beibehalt ihrer Lage zueinander - zur Tragachse und um die Tragachse schwenkbar sind,
∘ dass die Kupplungsanordnung (12) angetrieben ist und eine angetriebene zweite Kupplungseinheit (28) der Kupplungsanordnung (12) in Hochrichtung beabstandet zur ersten Kupplungseinheit (24) vorgesehen ist, sowie
∘ dass das Fahrwerk (6) und der Transportbehälter (1) als Arbeitseinheit (7) über die angetriebene zweite Kupplungseinheit (28) in die in Hochrichtung zur Fahrebene (11) abgehobene Anschlusslage zu einer jeweiligen Arbeitsstation (8) verschwenkbar und über diese fixiert mit der Arbeitsstation verbunden sind.

2. Reinraum-Transportbehälter mit Fahrwerk nach Anspruch 1, **dadurch gekennzeichnet**,
∘ dass der Transportbehälter (1) und das Fahrwerk (6) gegeneinander lagefest abgestützt und zu einer gemeinsam verschwenkbaren Arbeitseinheit (7) zusammengefasst in ihrer Andocklage zu einer jeweiligen Arbeitsstation (8) und in ihrer Fahrlage zur Fahrebene (11) unterschiedlich geneigt sind, derart, dass die Arbeitseinheit (7) insgesamt eine zur Andockebene (13) winklig gegen die Fahrebene (11) abgesetzte Fahrlage aufweist, und
∘ dass die zweite Kupplungseinheit (28) eine gesteuerte, auf die Arbeitseinheit (7) zugreifende und mit dieser zu verbindende Stelleinrichtung (29) aufweist, über die die über die erste Kupplungseinheit (24) abgestützte, beräderte Arbeitseinheit (7) gegen die Andockebene (13) in ihre gegenüber der Fahrebene (11) abgehobene Andocklage verschwenkbar ist.

3. Reinraum-Transportbehälter nach einem der vorhergehenden Ansprüche,
**dadurch gekennzeichnet,**
**dass** das Fahrwerk (6) einen über die Laufräder (14) getragenen Aufbau (15) aufweist, der sich in der über die Laufräder (14) auf der Fahrebene (11) abgestützten Fahrlage der Arbeitseinheit (7) zur Fahrebene (11) geneigt erstreckt.

4. Reinraum-Transportbehälter nach einem der vorhergehenden Ansprüche,
**dadurch gekennzeichnet,**
**dass** der Aufbau (15) ein Traggerüst aufweist, das zur Fahrebene (11) in der Fahrlage eine zur Neigung des Transportbehälters (1) komplementäre Neigung aufweist.

5. Reinraum-Transportbehälter nach einem der vorhergehenden Ansprüche,
**dadurch gekennzeichnet,**
**dass** eine seitens des Fahrwerks (6) vorgesehene Tragauflage (21) für den aufgesetzten Transportbehälter (1) Antriebs- und Verriegelungseinrichtungen für den Transportbehälter (1) in der Arbeitseinheit (7) aufweist.

6. Reinraum-Transportbehälter nach einem der vorhergehenden Ansprüche,
**dadurch gekennzeichnet,**
**dass** die seitens des Fahrwerks (6) vorgesehene Tragauflage (21) in der Andocklage und in der Fahrlage des Fahrwerkes (6) zur Fahrebene (11) unterschiedlich und in der Fahrlage des Fahrwerks (6) in Andockrichtung ansteigend zur Fahrebene (11) geneigt ist.

7. Reinraum-Transportbehälter nach Anspruch 5 oder 6,
**dadurch gekennzeichnet,**
**dass** die Tragauflage (21) Funktionselemente zur Identifizierung des Transportbehälters (1), zur Positionierung des Transportbehälters (1) gegenüber dem Fahrwerk (6) und/oder zur Positionierung des Fahrwerks (6) aufweist.

8. Reinraum-Transportbehälter nach einem der vorhergehenden Ansprüche,
**dadurch gekennzeichnet,**
**dass** bei in die Andocklage eingeschwenktem Transportbehälter (1) im Übergang auf eine Arbeitsstation (8) eine Seitenkammer (36) vorgesehen ist, die als Zwischenbauteil (41, 42) einen Antrieb für die Verstellung von in der Andocklage einander gegenüberliegenden Deckeln (33, 34) zum Transportbehälter (1) und einer gegenüberliegenden Arbeitsstation (8) aufnimmt.

## Claims

1. Clean-room transport container with travel gear,
∘ wherein the atmospherically sealed transport container (1) for substrates (4) has a closable end-face loading opening (3) and, carried as a working unit (7) via the wheeled travel gear (6) sitting on a travel plane (11), is to be moved into a starting position for docking against a docking plane (13) of a workstation (8), in a travel position that is inclined with respect to the docking plane (13),
∘ wherein a coupling arrangement (12) is provided with a coupling unit (24) via which, in the starting position for the docking, the travel gear (6) and the transport container (1) carried by the latter are supported as a working unit (7) on the travel-gear side in the vicinity of the travel plane (11) and adjacent to the docking plane (13) of the workstation (8), and also are detected and held via a pivot axis, and
∘ wherein the transport container (1) can be pivoted into a docking position with respect to the workstation (8),
characterized
∘ in that the pivot axis for the working unit (7) comprising the travel gear (6) and the transport container (1) is formed by rotary supports (25) which each define an axis of rotation, which is parallel to the docking plane (13) of the workstation (8), as a carrying axis and are each formed by a supporting ball (26) which is fixed in position with respect to the workstation,
∘ in that the travel gear (6) and the transport container (1) carried via the travel gear (6) are mutually secured in position with respect to the carrying axis and are pivotable overall - as a working unit (7) connected in a positionally fixed manner and pivotable, while retaining their position with respect to one another - with respect to the carrying axis and about the carrying axis,
∘ in that the coupling arrangement (12) is driven, and a driven second coupling unit (28) of the coupling arrangement (12) is provided spaced apart in the vertical direction from the first coupling unit (24), and
∘ in that the travel gear (6) and the transport container (1) as a working unit (7) are pivotable via the driven second coupling unit (28) into the connection position with respect to a respective workstation (8), said connection position being raised in the vertical direction with respect to the travel plane (11), and are connected to the workstation in a manner fixed via said connection position.

2. Clean-room transport container with travel gear according to Claim 1, characterized
∘ in that the transport container (1) and the travel gear (6) are supported in a fixed position relative to each other and, combined to form a jointly pivotable working unit (7), are differently inclined in their docking position with respect to a respective workstation (8) and in their travel position with respect to the travel plane (11) in such a manner that the working unit (7) as a whole has a travel position placed against the travel plane (11) at an angle to the docking plane (13), and
∘ in that the second coupling unit (28) has a controlled actuating device (29) which grips the working unit (7) and is to be connected to the latter and via which the wheeled working unit (7), which is supported via the first coupling unit (24), can be pivoted towards the docking plane (13) into its docking position which is raised in relation to the travel plane (11).

3. Clean-room transport container according to one of the preceding claims,
**characterized**
**in that** the travel gear (6) has a structure (15) which is carried via the running wheels (14) and extends at an inclination to the travel plane (11) in the travel position of the working unit (7) supported on the travel plane (11) via the running wheels (14).

4. Clean-room transport container according to one of the preceding claims,
**characterized**
**in that** the structure (15) has a carrying frame which has an inclination complementary to the inclination of the transport container (1) with respect to the travel plane (11) in the travel position.

5. Clean-room transport container according to one of the preceding claims,
**characterized**
**in that** a carrying support (21), which is provided on the travel gear (6), for the transport container (1) placed thereon has drive and locking devices for the transport container (1) in the working unit (7).

6. Clean-room transport container according to one of the preceding claims,
**characterized**
**in that** the carrying support (21), which is provided on the travel gear (6), is inclined differently with respect to the travel plane (11) in the docking position and in the travel position of the travel gear (6) and in a manner rising in the docking direction with respect to the travel plane (11) in the travel position of the travel gear (6).

7. Clean-room transport container according to Claim 5 or 6,
**characterized**
**in that** the carrying support (21) has functional elements for identifying the transport container (1), for positioning the transport container (1) in relation to the travel gear (6) and/or for positioning the travel gear (6).

8. Clean-room transport container according to one of the preceding claims,
**characterized**
**in that**, when the transport container (1) is pivoted into the docking position, a side chamber (36) is provided in the transition to a workstation (8), said side chamber as an intermediate component (41, 42) accommodating a drive for adjusting covers (33, 34), which are mutually opposite in the docking position, for the transport container (1) and an opposite workstation (8).

## Revendications

1. Conteneur de transport destiné à une salle blanche et pourvu d'un mécanisme de roulement,
∘ le conteneur de transport (1) étanche à l'atmosphère et destiné à des substrats (4) comportant une ouverture de chargement côté frontal fermable (3) et pouvant être déplacé, en étant porté par le mécanisme de roulement (6) monté sur roues et siégeant dans un plan de roulement (11) en tant qu'unité de travail (7) jusque dans une position de départ pour s'amarrer contre un plan d'amarrage (13) d'un poste de travail (8) dans une position de roulement inclinée par rapport au plan d'amarrage (13),
∘ un ensemble d'accouplement (12) pourvu d'une unité d'accouplement (24) étant prévu qui permet, dans la position de départ pour l'amarrage, de saisir et de supporter et maintenir sur un axe de pivotement le mécanisme de roulement (6), et les conteneurs de transport (1) portés par celui-ci, en tant qu'unité de travail (7) du côté mécanisme de roulement à proximité du plan de roulement (11) et de manière adjacente au plan d'amarrage (13) du poste de travail (8), et
∘ le conteneur de transport (1) pouvant être pivoté jusque dans une position d'amarrage au poste de travail (8),
**caractérisé en ce que**
∘ l'axe de pivotement de l'unité de travail (7), comprenant le mécanisme de roulement (6) et le conteneur de transport (1), est formé par des supports rotatifs (25) qui définissent chacun un axe de rotation, parallèle au plan d'amarrage (13) du poste de travail (8), en tant qu'axe de support et qui sont chacun formés par une bille de support (26) dont la position est fixe par rapport au poste de travail,
∘ le mécanisme de roulement (6) et le conteneur de transport (1), porté par le mécanisme de roulement (6), sont fixés en position l'un par rapport à l'autre et par rapport à l'axe de transport et dans leur ensemble peuvent être pivotés par rapport à l'axe de transport et autour de l'axe de transport, en tant qu'unité de travail pivotante (7) reliée de manière fixe en position tout en conservant leur position l'un par rapport à l'autre,
∘ l'ensemble d'accouplement (12) est entraîné et une deuxième unité d'accouplement entraînée (28) de l'ensemble d'accouplement (12) est prévue à une distance de la première unité d'accouplement (24) dans la direction verticale, et
∘ le mécanisme de roulement (6) et le conteneur de transport (1) peuvent être pivotés en tant qu'unité de travail (7), par le biais de la deuxième unité d'accouplement entraînée (28), jusque dans la position de raccordement à un poste de travail respectif (8), laquelle position est soulevée dans la direction verticale par rapport au plan d'entraînement (11), et sont reliés au poste de travail en étant fixés par celui-ci.

2. Conteneur de transport destiné à une salle blanche et pourvu d'un mécanisme de roulement selon la revendication 1,
**caractérisé en ce que**
∘ le conteneur de transport (1) et le mécanisme de roulement (6) sont supportés dans une position fixe l'un contre l'autre et, en étant combinés pour former une unité de travail pivotante commune (7), sont inclinés différemment dans leur position d'amarrage par rapport à un poste de travail respectif (8) et dans leur position de roulement par rapport au plan de roulement (11) de sorte que l'unité de travail (7) comporte en tout une position de roulement décalée angulairement par rapport au plan d'amarrage (13) vers le plan de roulement (11), et
∘ la deuxième unité d'accouplement (28) comporte un dispositif de réglage commandé (29) qui accède à l'unité de travail (7), qui peut être relié à celle-ci et permet de faire pivoter l'unité de travail (7), montée sur roues et supportée par la première unité d'accouplement (24), vers le plan d'amarrage (13) dans sa position d'amarrage qui est soulevée par rapport au plan de roulement (11).

3. Conteneur de transport destiné à une salle blanche selon l'une des revendications précédentes,
**caractérisé en ce que**
le mécanisme de roulement (6) comporte une structure (15) qui est portée par les roues porteuses (14) et qui s'étend de manière inclinée par rapport au plan de roulement (11) dans la position de roulement de l'unité de travail (7), supportée par les roues porteuses (14) sur le plan de roulement (11).

4. Conteneur de transport destiné à une salle blanche selon l'une des revendications précédentes,
**caractérisé en ce que**
la structure (15) comporte un cadre porteur qui présente, par rapport au plan de roulement (11) dans la position de roulement, une inclinaison complémentaire de l'inclinaison du conteneur de transport (1).

5. Conteneur de transport destiné à une salle blanche selon l'une des revendications précédentes,
**caractérisé en ce que**
un support (21), prévu du côté du mécanisme de roulement (6) et destiné au conteneur de transport (1) mis en place, comporte des dispositifs d'entraînement et de verrouillage du conteneur de transport (1) dans l'unité de travail (7).

6. Conteneur de transport destiné à une salle blanche selon l'une des revendications précédentes,
**caractérisé en ce que**
le support (21), prévu du côté du mécanisme de roulement (6), est incliné par rapport au plan de roulement (11) de manière différente dans la position d'amarrage et dans la position de roulement du mécanisme de roulement (6) et est incliné par rapport au plan de roulement (11), en montant dans la direction d'amarrage, dans la position de roulement du mécanisme de roulement (6).

7. Conteneur de transport destiné à une salle blanche selon la revendication 5 ou 6,
**caractérisé en ce que**
le support (21) comporte des éléments fonctionnels destinés à identifier le conteneur de transport (1), à positionner le conteneur de transport (1) par rapport au mécanisme de roulement (6) et/ou à positionner le mécanisme de roulement (6).

8. Conteneur de transport destiné à une salle blanche selon l'une des revendications précédentes,
**caractérisé en ce que**
lorsque le conteneur de transport (1) est pivoté dans la position d'amarrage, une chambre latérale (36) est prévue dans la transition vers un poste de travail (8) et reçoit, en tant que composant intermédiaire (41, 42), un entraînement destiné à déplacer des couvercles (33, 34), opposés les uns aux autres dans la position d'amarrage, par rapport au conteneur de transport (1) et à un poste de travail opposé (8).
